(19) Europäisches Patentamt
European Patent Office
Office européen des brevets

(11) **EP 2 156 201 B1**

(12) **FASCICULE DE BREVET EUROPEEN**

(45) Date de publication et mention
de la délivrance du brevet:
**22.11.2017 Bulletin 2017/47**

(21) Numéro de dépôt: **08806044.7**

(22) Date de dépôt: **19.06.2008**

(51) Int Cl.:
*G01R 27/26* (2006.01)      *G01R 29/24* (2006.01)
*G01R 31/14* (2006.01)      *G01R 31/12* (2006.01)

(86) Numéro de dépôt international:
**PCT/FR2008/051110**

(87) Numéro de publication internationale:
**WO 2009/004260 (08.01.2009 Gazette 2009/02)**

(54) **SYSTÈME D'ÉMISSION D'IMPULSION ÉLECTRIQUE ET DISPOSITIF DE DÉCOUPLAGE CAPACITIF POUR UN TEL SYSTÈME**

SYSTEM ZUR AUSSENDUNG EINES ELEKTRISCHEN IMPULSES UND VORRICHTUNG ZUR KAPAZITIVEN ENTKOPPLUNG FÜR EIN SOLCHES SYSTEM

SYSTEM FOR EMITTING AN ELECTRIC PULSE AND DEVICE FOR CAPACITIVE DECOUPLING FOR SUCH A SYSTEM

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **20.06.2007 FR 0704393**

(43) Date de publication de la demande:
**24.02.2010 Bulletin 2010/08**

(73) Titulaire: **Centre National d'Etudes Spatiales**
**75001 Paris (FR)**

(72) Inventeurs:
• **PAYAN, Denis**
**31320 Mervilla (FR)**
• **SCHWANDER, Denis**
**31860 Labarthe Sur Leze (FR)**

(74) Mandataire: **Lavoix**
**2, place d'Estienne d'Orves**
**75441 Paris Cedex 09 (FR)**

(56) Documents cités:
**EP-A- 1 443 687**

• **FUKUNAGA K ET AL: "Internal space charge measurement for space environment monitoring" PROCEEDINGS OF THE 7TH. INTERNATIONAL CONFERENCE ON PROPERTIES AND APPLICATIONS OF DIELECTRIC MATERIALS. NAGOYA, JAPAN, JUNE 1 - 5, 2003; [PROCEEDINGS OF THE INTERNATIONAL CONFERENCE ON PROPERTIES AND APPLICATIONS OF DIELECTRIC MATERIALS], NEW YORK,, vol. 2, 1 juin 2003 (2003-06-01), pages 662-664, XP010649209 ISBN: 978-0-7803-7725-7**
• **TATSUO TAKADA: "Acoustic and Optical Methods for Measuring Electric Charge Distributions in Dielectrics" IEEE TRANSACTIONS ON DIELECTRICS AND ELECTRICAL INSULATION, IEEE SERVICE CENTER, PISCATAWAY, NJ, US, vol. 6, no. 5, 1 octobre 1999 (1999-10-01), pages 519-547, XP011084321 ISSN: 1070-9878**
• **WU ET AL: "Capacitively decoupled tunable loop microstrip (TLM) array at 7 T" MAGNETIC RESONANCE IMAGING, ELSEVIER SCIENCE, TARRYTOWN, NY, US, vol. 25, no. 3, 19 mars 2007 (2007-03-19), pages 418-424, XP005933059 ISSN: 0730-725X**

**Description**

L'invention se rapporte à un système d'émission d'impulsion électrique pour appareil de détermination d'une répartition de charges contenues dans l'épaisseur d'un élément en matériau diélectrique.

L'invention vise en particulier à permettre à la fois le découplage électrique d'une électrode émettrice d'une impulsion électrique, à partir de laquelle la répartition de charge peut être déterminée, et la polarisation haute tension de l'électrode émettrice.

Le système selon l'invention permet d'identifier une répartition de charges dans l'épaisseur d'un élément diélectrique chargé électriquement avec une meilleure efficacité au niveau de la transmission de l'impulsion excitatrice.

On connaît des systèmes d'analyse de répartition de charges dans l'épaisseur des éléments qui permettent d'appliquer une méthode dite « électroacoustique pulsée » (ou « méthode PEA »). Cette méthode dite « PEA » vise à déterminer la densité, la répartition et la polarité des charges contenues dans l'élément à analyser.

L'article de Fukunaga et al., "Internai space charge measurement for space environment monitoring" (Proceedings of the 7th International Conference on Properties and Applications of Dielectric Materials, Nagoya, Japan, Juin 1-5 2003, vol. 2, 1 juin 2003, pages 662-664) divulgue un système d'émission d'au moins une impulsion électrique pour un appareil de détermination de la répartition de charges contenues dans l'épaisseur d'un élément en matériau diélectrique; ce système d'émission comporte une électrode émettrice d'au moins une impulsion, un générateur de ladite impulsion et des moyens d'adaptation d'impédance. L'article de Tatsuo Takada, "Acoustic and Optical Methods for Measuring Electric Charge Distributions in Dielectrics" (IEEE Transactions on Dielectrics and Electrical Insulation, vol. 6, no. 5, 1 octobre 1999, pages 519-547) divulgue un système d'émission d'au moins une impulsion électrique comportant un échantillon et une électrode; cette article précise uniquement que les impédances acoustiques de l'échantillon et de l'électrode doivent être égales. Le principe de la méthode PEA consiste à appliquer une impulsion de courte durée sur un élément placé entre deux électrodes, dans le but de sonder le matériau. Sous l'effet de l'impulsion électrique initiale, les charges contenues dans le matériau se déplacent parallèlement au champ électrique produit et reviennent à leur position initiale. Ce déplacement de charges génère une onde électroacoustique qui se propage dans la direction du champ. Cette onde, dont l'amplitude est proportionnelle à la quantité de charges contenues ou induites sur les électrodes, se dirige vers la surface de l'élément analysé à une vitesse qui est propre au matériau dans lequel est réalisé l'élément analysé. La profondeur des charges dans l'élément est déduite de cette vitesse. L'électrode réceptrice est équipée d'un capteur piézo-électrique qui transforme l'onde acoustique en signal électrique. Ce dernier est amplifié et transmis à un oscilloscope de mesure qui permet de visualiser le signal. Un système de traitement de données du signal électrique, associé à un logiciel et renseigné avec une mesure de référence, délivre alors des informations concernant la distribution spatiale des charges contenues dans l'élément analysé.

Une telle méthode est notamment décrite dans l'article intitulé « INNOVATIVE PEA SPACE CHARGE MEASUREMENT SYSTEMS FOR INDUSTRIAL APPLICATIONS » (IEEE Electrical Insulation Magazine, March/April 2004-Vol. 20, No2).

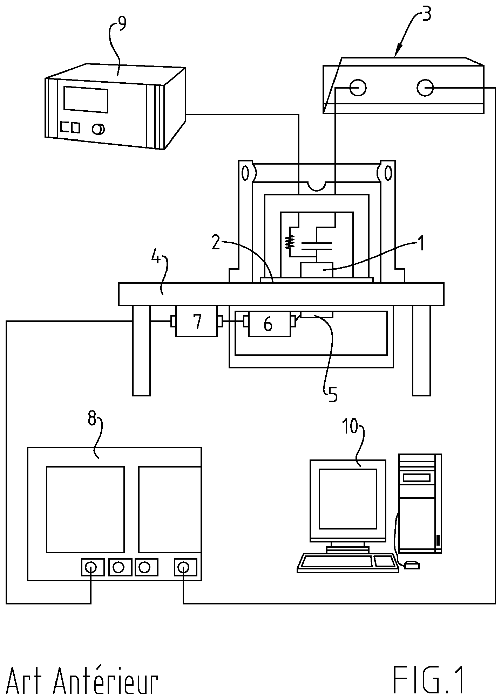

Un système permettant de mettre en oeuvre cette méthode PEA est illustré schématiquement en figure 1.

Il comporte une électrode 1 émettrice d'une impulsion dans un élément 2 à analyser, l'élément étant réalisé dans un matériau diélectrique, l'électrode 1 étant reliée à un générateur 3 de l'impulsion, apte à générer une onde acoustique traversant l'élément 2. Le système comporte également un support apte à supporter l'élément 2 à analyser, ledit support étant relié à une électrode réceptrice 4, équipée d'un capteur piézo-électrique 5 apte à capter l'onde acoustique générée par l'impulsion et à la transformer en signal électrique pour matérialiser l'onde générée par l'impulsion sur un oscilloscope, de sorte à analyser la répartition géographique des charges stockées.

Le système comporte également des amplificateur et filtre 6 et 7 disposés en sortie du capteur, assurant l'amplification du signal de manière à pouvoir l'analyser et le visualiser sur un oscilloscope 8 disposé en aval. Enfin, l'électrode émettrice 1 peut être alimentée en tension par une alimentation 9.

Un ordinateur 10 est relié d'une part à l'oscilloscope 8 pour recevoir le signal électrique et analyser les données qu'il comporte. L'ordinateur 10 est d'autre part relié au générateur d'impulsion 3 de sorte à être informé des paramètres de l'impulsion initiale transmise par l'électrode émettrice. On peut ainsi déterminer la répartition des charges stockées dans ledit élément et visualiser les résultats sous forme de tableaux ou de représentation en trois dimensions, via l'écran de l'ordinateur 10.

Un tel système présente plusieurs inconvénients, dont notamment celui d'une déformation du signal appliqué à l'élément 2 en particulier lors de la transmission d'impulsion au niveau de l'électrode émettrice 1.

L'invention vise à réaliser un système d'émission d'au moins une impulsion électrique qui soit plus performant que celui illustré en figure 1, en palliant les inconvénients évoqués ci-dessus.

L'invention concerne un système d'émission d'au moins une impulsion électrique pour appareil de détermination d'une répartition de charges contenues dans l'épaisseur d'un élément en matériau diélectrique, ledit système d'émission comportant une électrode émettrice d'au moins une impulsion et un générateur de ladite impulsion. Le système selon l'invention est remarquable en ce que l'électrode est constituée par une ligne de transmission sensiblement plane au regard de l'élément à analyser et qui comporte des moyens d'adaptation d'impédance pour maintenir sensiblement constante ladite impédance le long de ladite ligne de transmission dans la bande passante de ladite impulsion.

L'électrode sensiblement plane combinée au moyens d'adaptation d'impédance permet de transmettre l'impulsion sans déformation.

De plus, l'invention offre une solution technique plus efficace pour adapter l'impédance, comparée à celles proposées par l'état de la technique qui prévoient notamment d'introduire des composants discrets.

Suivant des modes de réalisation de l'invention, le système peut comprendre les caractéristiques suivantes, prises séparément ou en combinaison :

- les moyens d'adaptation d'impédance comportent des moyens de liaison électrique entre, d'une part, le générateur d'impulsion et une extrémité de l'électrode émettrice,et d'autre part entre une seconde extrémité de l'électrode émettrice et une charge dont l'impédance est égale à l'impédance caractéristique de l'électrode,
- les moyens de liaison sont des câbles coaxiaux,
- l'impédance est sensiblement de 50 Ohms,
- ladite charge est constituée par un circuit d'absorption du signal situé en aval de ladite électrode,
- le système comporte des moyens d'application d'une tension électrique de polarisation à ladite électrode et au moins un dispositif de découplage capacitif de ladite électrode disposé à une extrémité de ladite électrode,
- ledit dispositif de découplage comporte au moins un condensateur compatible avec la tension électrique, et des éléments d'adaptation de l'impédance dudit condensateur,
- ledit condensateur a une forme allongée et lesdits éléments d'adaptation comportent au moins une armature métallique disposée au voisinage d'une extrémité de connexion dudit condensateur, ladite armature venant entourer ledit condensateur sensiblement sur toute sa longueur,
- il comporte au moins deux armatures métalliques, chacune des armatures étant disposée au voisinage d'une extrémité de connexion dudit condensateur, les deux armatures étant séparées par un élément isolant appartenant au groupe comprenant l'air, le vide et un matériau diélectrique,
- lesdites armatures sont disposées tête-bêche,
- les bords libres des armatures se chevauchent autour dudit condensateur,
- ledit dispositif de découplage comporte un boîtier comprenant ledit condensateur et lesdits éléments d'adaptation, ledit boîtier comprenant au moins deux connecteurs et étant relié à un plan de masse,
- ledit dispositif de découplage capacitif comporte au moins une ligne micro ruban présentant une découpe transversale, ladite découpe transversale séparant ladite ligne micro ruban en deux parties reliées entre elles par des condensateurs de découplage,
- ladite électrode émettrice comporte une ligne micro ruban présentant à chacune de ses extrémités une découpe traversante, séparant ladite ligne micro ruban en deux partie latérales et une partie centrale, ladite partie centrale étant reliée à chacune des parties latérales par des condensateurs, chaque ensemble découpe traversante/condensateurs/partie latérale qui est situé à chaque extrémité de ladite ligne micro ruban constituant un dispositif de découplage capacitif.

L'invention vise également un dispositif de découplage capacitif pour système d'émission d'au moins une impulsion électrique tel que défini ci-dessus, remarquable en ce qu'il comporte au moins un condensateur compatible avec la tension électrique, et des éléments d'adaptation de l'impédance dudit condensateur.

Suivant d'autres caractéristiques du dispositif selon l'invention, prises séparément ou en combinaison :

- le condensateur a une forme allongée et lesdits éléments d'adaptation comportent au moins une armature métallique disposée au voisinage d'une extrémité de connexion dudit condensateur, ladite armature venant entourer ledit condensateur sensiblement sur toute sa longueur,
- le dispositif comporte au moins deux armatures métalliques, chacune des armatures étant disposée au voisinage d'une extrémité de connexion dudit condensateur, les deux armatures étant séparées par un élément isolant appartenant au groupe comprenant l'air, le vide et un matériau diélectrique,
- une armature présente une forme de coupelle,
- lesdites armatures sont disposées tête-bêche,
- les bords libres des armatures se chevauchent autour dudit condensateur,
- le dispositif comporte un boîtier comprenant ledit condensateur et lesdits éléments d'adaptation, ledit boîtier comprenant au moins deux connecteurs,
- le dispositif comporte au moins une ligne micro ruban présentant une découpe transversale, ladite découpe transversale séparant ladite ligne micro ruban en deux parties reliées entre elles par des condensateurs de découplage.

L'invention concerne enfin une électrode émettrice pour système d'émission d'une impulsion électrique, tel que défini ci-dessus, remarquable en ce qu'elle comporte une ligne micro ruban présentant à chacune de ses extrémités une découpe traversante, séparant ladite ligne micro ruban en deux partie latérales et une partie centrale, ladite partie centrale étant reliée à chacune des parties latérales par des condensateurs, chaque ensemble découpe traversante/condensateurs partie latérale qui est situé à chaque extrémité de ladite ligne micro ruban constituant un dispositif de découplage capacitif.

L'invention sera davantage comprise à la lumière de la description d'exemples de réalisation de l'invention, en faisant référence aux figures annexées parmi lesquelles :

- la figure 1 représente schématiquement un système selon l'art antérieur, tel que décrit ci-avant ;
- la figure 2 illustre schématiquement un premier mode de réalisation d'un système d'émission d'au moins une charge électrique selon l'invention, mis en oeuvre au- dessus d'un élément en matériau diélectrique dont la répartition de charges doit être déterminée,
- la figure 3 illustre schématiquement un second mode de réalisation d'un système selon l'invention, mis en oeuvre au-dessus d'un élément en matériau diélectrique dont la répartition de charges doit être déterminée,
- la figure 4 illustre un troisième mode de réalisation d'un système selon l'invention, mis en oeuvre au-dessus d'un élément en matériau diélectrique dont la répartition de charges doit être déterminée,
- la figure 5 est une vue de dessus d'un dispositif de découplage selon l'invention conforme à un premier mode de réalisation, enfermé dans un boîtier,
- la figure 6 est une vue analogue à celle de la figure 5, sur laquelle le dispositif de découplage capacitif n'est pas enfermé dans un boîtier,
- la figure 7 est une vue de dessus d'un dispositif de découplage selon l'invention conforme à un second mode de réalisation,
- la figure 8 est une vue de dessus d'un dispositif de découplage selon l'invention conforme à un troisième mode de réalisation,
- la figure 9 est une vue de côté d'un dispositif de découplage selon l'invention conforme à un quatrième mode de réalisation,
- et la figure 10 illustre un cinquième mode de réalisation d'un dispositif de découplage selon l'invention, mis en oeuvre au-dessus d'un élément en matériau diélectrique dont la répartition de charge doit être déterminée.

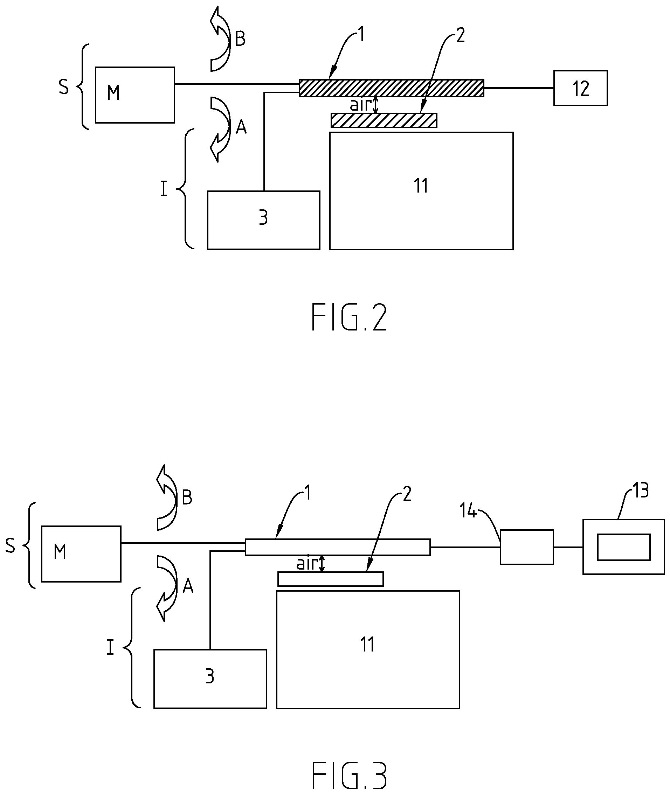

Un premier mode de réalisation d'un système d'émission d'au moins une charge électrique selon l'invention est maintenant décrit en faisant référence à la figure 2.

La figure 2 présente schématique un appareil complet, apte à déterminer la répartition de charge dans un élément diélectrique 2.

L'appareil complet comporte deux parties : une partie supérieure S et une partie inférieure I. La partie supérieure S est amovible par exemple en étant montée mobile entre une position d'analyse, illustrée par la flèche portant la référence A, où elle fait face à la partie fixe, et une position d'irradiation, illustrée par la flèche portant la référence B, où elle est éloignée de la partie fixe.

L'appareil selon ce mode de réalisation est équipé de moyens motorisés M pour faire passer la partie mobile de la position A à la position B, ou inversement.

La partie mobile supérieure S est, dans le cadre du présent exemple de réalisation, constituée d'un système d'émission d'au moins une impulsion électrique selon un premier mode de réalisation de l'invention qui sera détaillé ci-après.

La partie inférieure de l'appareil est connue en soit et constitue un module de détection et de traitement de signal 11.

Le module de détection et de traitement 11 comporte une électrode de détection (ou de réception), reliée à un capteur piézoélectrique, ce dernier étant lui-même relié à un filtre et à un amplificateur La sortie de l'amplificateur est relié à un oscilloscope permettant de visualiser un signal électrique, et notamment le signal électrique issu de l'onde acoustique susceptible d'être générée par le déplacement de charges stockées dans un élément 2 et dont on souhaite connaître la répartition.

Il peut être prévu de maintenir l'élément à analyser 2 sur l'électrode du module de détection 11 par une couche de colle.

La partie mobile S de l'appareil permet de transmettre à l'élément/échantillon 2 à analyser l'impulsion nécessaire à la génération d'une onde acoustique caractéristique des charges que l'élément 2 comporte, en minimisant la déformation de l'impulsion, afin d'obtenir la plus grande précision possible sur la quantité de charges détectées et l'implantation de celles-ci dans l'élément 2.

Le système S comporte une électrode émettrice 1 dont l'une des extrémités est reliée à un générateur d'impulsion 3, et dont l'autre extrémité est reliée à un circuit 12 dont l'impédance est égale à son impédance caractéristique.

Dans le cadre du présent exemple de réalisation, l'impédance de l'électrode émettrice 1 est fixée à 50 Ω. Le circuit 12 présente donc également une impédance à 50 Ω.

On obtient ainsi un système d'émission où l'impédance vue par l'impulsion est sensiblement constante le long de son cheminement sur la ligne de transmission entre le générateur 3 et la charge 20.

Le circuit 12 permet d'éviter le retour du signal ou de l'impulsion en « absorbant » le signal.

En effet, la réflexion du signal compliquerait l'analyse du signal électrique en sortie du capteur piézoélectrique du module 11 : le signal analysé serait représentatif de deux ondes acoustiques générées par les charges, la première onde correspondant à un premier mouvement des charges en réponse à la première impulsion, et la seconde onde correspondant à un second mouvement des charges en réponse à un retour d'impulsion.

Le circuit 12 permet ainsi d'absorber le signal et d'éviter sa déformation dans le système S.

Dans une variante de réalisation illustrée en figure 3, le circuit 12 est remplacé par un oscilloscope 13 et un dispositif atténuateur de signal 14 disposé en amont de l'oscilloscope 13. L'oscilloscope 13 permet d'observer l'impulsion après son parcours le long de la ligne de transmission et éventuellement de mesurer sa déformation.

Le circuit 12 ou l'atténuateur 14 ne sont pas indispensables si un retour du signal est toléré si le temps d'aller / retour de l'impulsion est supérieur au temps nécessaire à la mesure ou à l'analyse.

Quand le système selon l'invention S est placé en position d'analyse A, il existe un espace entre l'électrode émettrice 1 et la surface de l'élément à analyser 2 dans le cadre d'une mise en oeuvre sans contact. Cet espace, pouvant être par exemple de l'air ou du vide, constitue un diélectrique entre l'électrode émettrice 1 et l'élément à analyser 2.

Les deux exemples de systèmes conformes à la présente invention exposés ci-dessus permettent d'empêcher les déformations de signal ou d'impulsion lorsqu'il se propage entre le générateur 3 et l'électrode émettrice 1.

Dans le cadre des exemples de réalisation ci-dessus, les électrodes ne sont soumises à aucune tension de polarisation.

Toutefois, pour les besoins de l'expérimentation, il convient parfois de polariser l'électrode, c'est-à-dire de lui appliquer une tension électrique continue.

En effet, cette mise sous tension permet d'obtenir des valeurs étalons et / ou de soumettre l'élément 2 à analyser à un champs électrique, et / ou d'injecter des charges électrique dans l'élément 2 à analyser pour en mesurer les effets au cours du temps.

Pour réaliser cette polarisation par application d'une tension continue à l'électrode 1, celle-ci doit également être découplée, autrement dit «isolée électriquement», des autres éléments que comporte le système d'émission, afin d'appliquer une tension continue à l'électrode 1 et uniquement à elle seule.

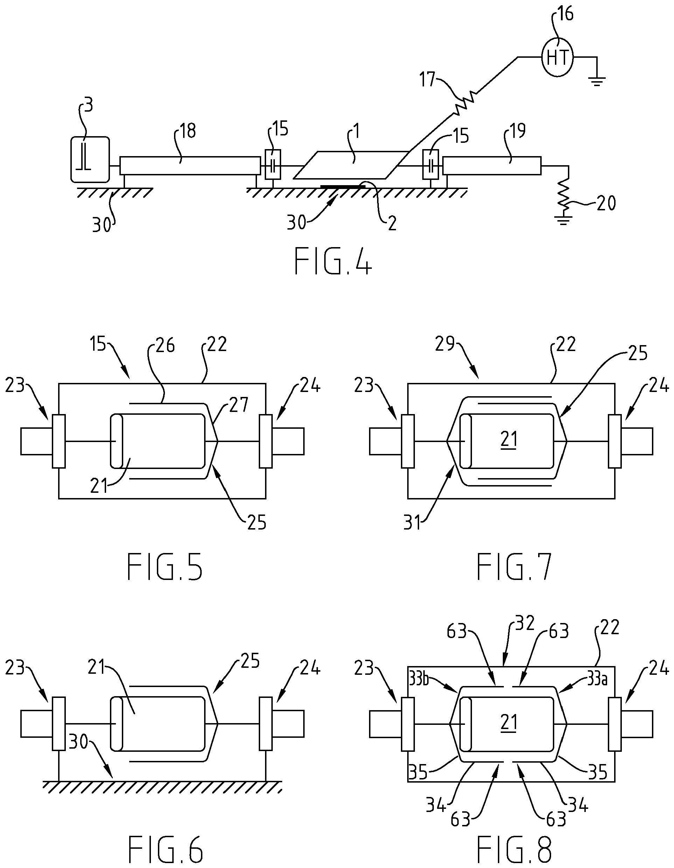

C'est pourquoi deux dispositifs de découplage à condensateur(s) 15 sont disposés de part et d'autre de l'électrode 1 comme illustré en figure 4.

La figure 4 montre l'électrode 1 disposée au dessus d'un élément échantillon à analyser 2, l'électrode 1 étant reliée à chacune de ses extrémités à l'un des deux dispositifs de découplage 15 et mise sous tension grâce à un générateur haute tension 16.

Une résistance à très forte valeur 17 est disposée entre le générateur haute tension 16 et l'électrode 1, pour limiter le courant en cas de court-circuit.

Pour éviter toute déformation du signal, des moyens de liaison 18 et 19 de même impédance que celle de l'électrode 1 sont reliés respectivement à un générateur d'impulsion 3 et à une charge 20 de même impédance que l'électrode 1, permettant d'absorber le signal ou l'impulsion.

Toutefois, pour que le système d'émission fonctionne, les dispositifs de découplage capacitif 15 doivent être adaptés à l'impédance des câbles ou moyens de liaison 18 et 19 auxquels ils sont connectés pour éviter la déformation de l'impulsion.

En effet, pour ne pas perturber l'impulsion de tension excitatrice incidente, il ne doit pas y avoir de rupture d'impédance entre l'électrode polarisée 1 et les câbles 18 et 19. Par conception, les condensateurs haute-tension ne sont pas adaptés quand ils sont simplement disposés entre deux éléments ou « lignes » présentant la même impédance, à cause de leur géométrie qui introduit un déséquilibre du rapport self inductance parasite/capacité parasite fonction de la structure du condensateur.

On appelle self inductance parasite du condensateur la self inductance des longueurs métalliques de celui-ci. La capacité parasite du condensateur est représentée par l'ensemble des capacités entre ses éléments métalliques et la référence de masse.

Comme la capacité du condensateur doit être de valeur suffisante pour constituer un court-circuit pour l'impulsion excitatrice, cela impose de rajouter dans le dispositif des condensateurs de découplage volumineux qui entraînent une désadaptation de la ligne de transmission.

Aussi, les dispositifs de découplage 15, connectés de part et d'autre de l'électrode 1, comme représentés schématiquement sur la figure 4 sont adaptés conformément à l'invention et font l'objet du dispositif selon l'invention dont des exemples de réalisation vont maintenant être décrits en faisant référence aux figures 5 à 9.

Un premier mode de réalisation conforme à l'invention d'un dispositif de découplage adapté 15 est illustré en figures 5 et 6.

Le dispositif de découplage capacitif 15 comporte un condensateur haute tension 21 qui est enfermé dans un boîtier 22, et dont les bornes sont reliées à deux connecteurs 23 et 24 du boîtier 22. Les deux connecteurs 23 et 24 permettent le branchement du boîtier 22 respectivement au câble 18 relié au générateur d'impulsion et à une extrémité de l'électrode émettrice 1.

Le condensateur 21 est un condensateur que l'on trouve aisément sur le marché, dont la capacité est par exemple de l'ordre de 250 pF jusqu'à une fréquence pouvant atteindre 1 GHz.

Le boîtier 22 est relié à un plan de masse 30 (voir figures 4 et 6).

Les moyens permettant d'adapter le dispositif de découplage 15 sont des moyens qui permettent d'augmenter la capacité parasite externe du condensateur.

Pour ce faire, et conformément au mode de réalisation illustré en figure 5 et 6, les éléments d'adaptation consistent en une armature métallique 25, réalisée (dans le cadre de cet exemple) sensiblement en forme de coupelle, c'est-à-dire en forme de cylindre creux métallique 26 présentant une extrémité fermée en forme de cône 27.

Dans le cadre de ce mode de réalisation, cette armature métallique 25 coiffe l'une des extrémités du condensateur 21, et la longueur du cylindre creux métallique est sensiblement égale, voire légèrement supérieure ou inférieure, à celle du condensateur, de sorte à l'entourer sensiblement complètement.

Un isolant, comme de l'air, circule entre l'armature métallique et le condensateur 21.

Grâce à la présence de cette armature métallique 25, la capacité parasite du dispositif de découplage capacitif adapté 15 est supérieure à la capacité parasite du condensateur 21 par rapport à la référence de masse. L'augmentation de capacité permet de corriger le rapport self inductance parasite / capacité parasite du condensateur de manière à maintenir adaptée la ligne de transmission.

Le dispositif de découplage capacitif 15 est ainsi adapté et permet une transmission de l'impulsion sans déformation ainsi qu'une mise sous tension de l'électrode 1.

La figure 7 montre une variante de réalisation d'un dispositif de découplage capacitif 29 selon l'invention, apte à remplacer le dispositif de découplage 15 illustré en figure 4 dans un système d'émission conforme à l'invention.

Le dispositif de découplage capacitif 29 comporte également un boîtier 22 comportant deux connecteurs 23 et 24, comme le celui du boîtier du dispositif de découplage 15 décrit précédemment. De plus, le boîtier 22 comporte un condensateur 21 connecté à chacun des connecteurs 23 et 24, le condensateur 21 étant entouré d'une première armature métallique 25 identique à celle du dispositif de découplage 15 décrit précédemment, en forme de coupelle, venant coiffer l'une des extrémité du condensateur 21.

Le dispositif de découplage capacitif 29 comporte en outre une seconde armature métallique 31.

La seconde armature métallique 31 présente également une forme de coupelle, comportant un cylindre creux métallique fermé à une extrémité par un cône creux métallique également.

La seconde armature métallique 31 coiffe l'autre extrémité du condensateur 21 et est disposée tête-bêche par rapport à la première armature métallique 25.

La seconde armature métallique 31 présente des dimensions supérieures à celles de la première armature métallique 25 de manière à entourer à la fois le condensateur 21 et l'armature 25.

Par ailleurs, une couche d'isolant électrique (de l'air dans le cas présent) est disposée entre les première 25 et seconde 31 armatures métalliques.

Ainsi réalisé, ce second dispositif de découplage capacitif 29 constitue un condensateur dont la capacité parasite est encore plus grande que celle du dispositif représenté en figures 5 et 6.

Il devra être compris que l'invention n'est pas limitée à la présence de deux armatures métalliques, et que le dispositif capacité conforme à l'invention pourrait en comprendre plus de deux.

La figure 8 montre encore un autre mode de réalisation de dispositif de découplage capacitif conforme à l'invention.

Le dispositif de découplage capacitif 32 comporte également un boîtier 22 comportant deux connecteurs 23 et 24, comme celui du boîtier des dispositifs de découplage 15 ou 22 décrits précédemment. De plus, le boîtier 22 comporte un condensateur 21 connecté à chacun des connecteurs 23 et 24.

Le condensateur 21 est entouré d'une première armature métallique 33a en forme de coupelle venant coiffer l'une des extrémités du condensateur 21.

L'armature métallique 33a comporte ainsi un cylindre métallique creux 34 fermé à l'une de ses extrémités par un cône métallique creux 35. Le diamètre du cylindre 34 est identique à celui du cylindre 26 de l'armature 25. Toutefois, le cylindre 34 est de longueur plus petite, sensiblement égale à la moitié de la longueur du condensateur 21.

Le condensateur est entouré d'une seconde armature métallique 33b identique à la première armature métallique 33a, coiffant l'autre extrémité du condensateur et disposée tête-bêche par rapport à la première armature métallique 33a.

Une couche d'air sépare les parois internes des deux cylindres 34 de la surface du condensateur 21. Une autre couche d'air sépare les deux extrémités libres respectives 63 des deux cylindres creux 34 qui se font face.

Un tel mode de réalisation permet également de réaliser un dispositif de découplage capacitif 32 dont la capacité parasite permet d'obtenir le bon rapport self inductance parasite / capacité parasite du condensateur, de manière à maintenir la ligne de transmission adaptée.

L'impédance caractéristique Zc est la suivante :

$$Zc = \sqrt{(Lp / Cp)}$$

où

Lp est la self inductance parasite, et
Cp est la capacité parasite.

La description qui précède donne des exemples de moyens permettant, à partir de condensateurs existants, du commerce, de réaliser des condensateurs adaptés pour un système d'émission selon l'invention.

Il devra toutefois être entendu que l'invention n'est pas limitée à des moyens techniques qui permettent d'adapter des condensateurs existants, et qu'elle couvre tout autre moyen permettant d'assurer un découplage capacitif de l'électrode émettrice 1 dans un système d'émission tel que décrit ci-dessus, c'est-à-dire un système qui évite toute déformation de l'impulsion lors son l'émission par l'électrode 1, et où l'électrode est soumise à une haute tension pour les besoins de l'expérimentation.

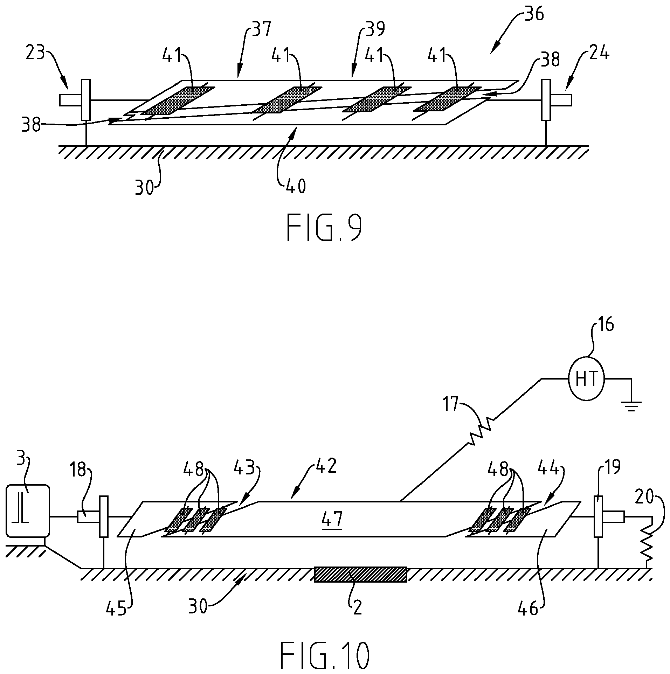

La figure 9 illustre par exemple un autre mode de réalisation de dispositif de découplage capacitif.

Ainsi, un dispositif de découplage capacitif 36 tel qu'illustré en figure 9 peut venir remplacer un dispositif de découplage capacitif 15 du système d'émission illustré en figure 4.

Le dispositif de découplage 36 est illustré en vue de côté et en perspective. Le boîtier 22 qui enferme le dispositif 36 n'est pas représenté sur la figure. Seuls les connecteurs 23 et 24 reliés au plan de masse 30 sont représentés.

Il devra toutefois être compris que le dispositif de découplage 36 comporte un boîtier 22 similaire à ceux des dispositifs de découplage 15, 29 ou 32 décrits précédemment.

Le dispositif de découplage 36 comporte une ligne micro ruban 37 réalisée, par exemple, en cuivre.

La ligne micro ruban 37 présente une découpe transversale 38, de sorte qu'elle est divisée en deux parties 39 et 40 séparées par la découpe 38.

Les parties 39 et 40 de la ligne micro ruban 37 sont reliées respectivement, l'une au connecteur 23, l'autre au connecteur 24 du boîtier 22.

La découpe 38 est réalisée suivant une diagonale de la ligne micro ruban 37, de sorte qu'elle présente la plus grande longueur possible pour des raisons qui vont maintenant être exposées.

Les deux parties 39 et 40 sont reliées entre elles par des condensateurs 41 de capacité individuelle plus petite que celles des condensateurs 21 utilisés dans le cadre des modes de réalisations des dispositifs 15, 29, 32 décrits précédemment.

Plus la longueur de la fente est grande, plus on peut prévoir de condensateurs entre les deux parties 39 et 40 de la ligne micro ruban. Pour obtenir une fente de grande longueur, on peut par exemple la disposer selon une diagonale de la ligne micro ruban 37.

Il devra toutefois être compris que l'on pourrait réaliser un dispositif en utilisant une ligne micro ruban présentant une découpe en deux parties réalisée suivant sa longueur, ou sa largeur, ou suivant un quelconque autre dessin rectiligne ou sinueux, sans pour autant sortir du cadre de l'invention.

Un tel mode de réalisation permet de réaliser un dispositif de découplage capacitif 36 formé par la ligne micro ruban 37 avec la découpe 38 et les condensateurs 41, capable de résister à des valeurs très élevées de tension, par exemple 10 000 Volts, appliquées à l'électrode émettrice 1 à laquelle il est relié. La taille des condensateurs 41 est suffisamment petite pour ne pas nécessiter d'adaptation d'impédance individuelle du type de celle des exemples des figures 5 à 8.

Un dispositif capable de résister à une telle tension peut comporter une ligne micro ruban dont les dimensions obéissent à la règle qui suit.

Si W est la largeur du ruban (ou piste conductrice) de la ligne micro ruban, et h l'épaisseur du matériau diélectrique sur laquelle le ruban (ou la piste) est placé. Le calcul du rapport W/h correspondant à une impédance $Z_o$ fixée, est donnée par la formule suivante :

pour W/h > 2 :

$$\frac{W}{h} = \frac{2}{\pi}\left\{B - 1 - \ln(2B-1) + \frac{\varepsilon_r + 1}{2\varepsilon_r}\left[\ln(B-1) + 0{,}39 - \frac{0{,}61}{\varepsilon_r}\right]\right\}$$

avec

$$B = \frac{377\pi}{2Z_0\sqrt{\varepsilon_r}}$$

et avec :

$Z_0$    impédance caractéristique de la ligne
W    largeur de la piste
t    épaisseur de la piste
h    épaisseur du diélectrique
$\varepsilon_r$    Constante diélectrique du matériau isolant (permittivité relative)

Les dimensions de la ligne micro ruban seront calculées de sorte à ne pas dépasser 10 kV / mm.

La largeur de la découpe 38 sera, dans le cadre de cet exemple de réalisation, au minimum de 1 mm.

La figure 10 montre encore un autre système d'émission conforme à l'invention, appliquant le principe de réalisation du dispositif de découplage capacitif 36 illustré en figure 9 à une électrode émettrice 42.

De manière similaire au système illustré en figure 4, l'électrode émettrice est disposée au-dessus d'un élément échantillon à analyser 2 et mise sous tension grâce à un générateur haute tension 16.

Une résistance de très forte valeur 17 est disposée entre le générateur haute tension 16 et l'électrode 42, de façon à découpler l'alimentation de l'électrode lors de l'application de la tension continue.

Pour éviter une déformation du signal, des moyens de liaison 18 et 19 de même impédance que celle de l'électrode 42 sont reliés respectivement à un générateur d'impulsion 3 et à une charge 20 de même impédance, permettant d'absorber le signal ou l'impulsion.

Pour assurer le fonctionnement du système, au lieu d'ajouter deux dispositifs de découplage 15, ou 29, ou 32 ou 36 adaptés à l'impédance des câbles 18 et 19, et à l'impédance de l'électrode émettrice, l'électrode 1 constituée d'une ligné micro ruban est remplacée par l'électrode 42 qui est modifiée pour permettre un découplage total de l'une de ses partie.

Pour ce faire, deux découpes transversales 43 et 44 sont réalisées sur toute la largeur de la ligne micro ruban de façon sensiblement parallèles entre elles, chaque découpe étant réalisée au voisinage de chacun des extrémités de la ligne micro ruban 42. Il devra être compris que les découpes pourraient avoir des orientations différentes sans sortir du cadre de l'invention.

La ligne micro ruban présente ainsi trois parties, dont deux parties d'extrémité 45 et 46 sont reliées respectivement aux connecteurs des moyens de liaison 18 et 19 , et une partie centrale 47 est reliée au générateur haute tension 16.

La partie centrale 47 fait face à l'échantillon de l'élément 2 dont il faut analyser la répartition de charges. C'est cette partie 47 de la ligne micro ruban qui émettra l'impulsion permettant de déterminer la répartition de charge dans l'échantillon de l'élément 2.

Les parties d'extrémités 45 et 46 sont reliées à la partie centrale 47 par des condensateurs individuels 48, qui peuvent être les mêmes que ceux 41 utilisés dans le mode de réalisation du dispositif 36, ou qui peuvent être différents.

Ainsi, chaque partie d'extrémité 45 et 46, en combinaison avec la partie centrale 47 et les condensateurs 48 qui la connecte avec celle-ci, constitue un dispositif de découplage capacitif.

Il résulte de la description qui précède que le système d'émission selon l'invention permet d'assurer une propagation du signal ou de l'impulsion émise par le générateur 3 jusqu'à l'électrode émettrice 1 ou 42 sans déformation, ce qui assure l'obtention de résultats meilleurs par rapport aux systèmes classiques de l'état de la technique, concernant la répartition de charges dans l'échantillon 2 d'élément à analyser. On comprend également comment, en combinaison, l'invention permet une isolation (ou un découplage électrique) de l'électrode pour autoriser la mise sous tension de cette dernière.

Il devra toutefois être compris que l'invention ne se limite pas spécifiquement aux modes de réalisations qui sont décrits et illustrés sur les figures, et qui sont uniquement présentés à titre d'exemples de réalisation.

En particulier, les dimensions et les formes des moyens permettant le découplage de l'électrode émettrice pourraient être différents sans toutefois sortir du cadre de l'invention.

**Revendications**

1. Système d'émission d'au moins une impulsion électrique pour appareil de détermination d'une répartition de charges contenues dans l'épaisseur d'un élément (2) en matériau diélectrique, ledit système d'émission comportant une électrode émettrice (1, 42) d'au moins une impulsion et un générateur (3) de ladite impulsion, <u>caractérisé en ce que</u> ladite électrode est constituée par une ligne de transmission (1) sensiblement plane au regard de l'élément (2) à analyser et qui comporte des moyens d'adaptation d'impédance pour maintenir sensiblement constante ladite impédance le long de ladite ligne de transmission dans la bande passante de ladite impulsion ; et **en ce que** lesdits moyens d'adaptation d'impédance (12, 13, 14, 18, 19, 20) comportent des moyens de liaison électrique (18, 19) entre, d'une part, le générateur d'impulsion (3) et une extrémité de l'électrode émettrice (1, 42), et d'autre part entre une seconde extrémité de l'électrode émettrice et une charge (20) dont l'impédance est égale à l'impédance caractéristique de l'électrode.

2. Système selon la revendication 1, **caractérisé en ce que** lesdits moyens de liaison (18, 19) sont des câbles coaxiaux.

3. Système selon la revendication 1 ou 2, **caractérisé en ce que** ladite impédance est sensiblement de 50 Ohms.

4. Système selon l'une quelconque des revendications 1 à 3, **caractérisé en ce que** ladite charge est constituée par un circuit d'absorption (12 ; 13, 14) du signal situé en aval de ladite électrode (1, 42).

5. Système selon l'une quelconque des revendications précédentes, **caractérisé en ce qu'**il comporte en outre des moyens (16, 17) d'application d'une tension électrique de polarisation à ladite électrode (1, 42) et au moins un dispositif de découplage capacitif (15, 29, 32, 36) de ladite électrode (1, 42) disposé à une extrémité de ladite électrode.

6. Système selon la revendication 5, **caractérisé en ce que** ledit dispositif de découplage (15, 29, 32, 36) comporte au moins un condensateur (21) compatible avec la tension électrique, et des éléments d'adaptation (25, 31, 33a et 33b) de l'impédance dudit condensateur.

7. Système selon la revendication 6, **caractérisé en ce que** ledit condensateur a une forme allongée et lesdits éléments d'adaptation (25, 31, 33a, 33b) comportent au moins une armature métallique (25, 31, 33a, 33b) disposée au voisinage d'une extrémité de connexion dudit condensateur (21), ladite armature venant entourer ledit condensateur (21) sensiblement sur toute sa longueur.

8. Système selon la revendication 6 ou 7, **caractérisé en ce qu'**il comporte au moins deux armatures métalliques (25, 31, 33a, 33b), chacune des armatures (25, 31, 33a, 33b) étant disposée au voisinage d'une extrémité de connexion dudit condensateur (21), les deux armatures (25, 31, 33a, 33b) étant séparées par un élément isolant appartenant au groupe comprenant l'air, le vide et un matériau diélectrique.

9. Système selon la revendication 8, **caractérisé en ce que** lesdites armatures (25, 31, 33a, 33b) sont disposées tête-bêche.

10. Système selon la revendication 9, **caractérisé en ce que** les bords libres des armatures (25, 31, 33a, 33b) se chevauchent autour dudit condensateur (21).

11. Système selon l'une quelconque des revendications 6 à 10, **caractérisé en ce que** ledit dispositif de découplage (15, 29, 32) comporte un boîtier (22) comprenant ledit condensateur (21) et lesdits éléments d'adaptation (25, 31, 33a, 33b), ledit boîtier (22) comprenant au moins deux connecteurs (23, 24) et étant relié à un plan de masse.

12. Système selon la revendication 5, **caractérisé en ce que** ledit dispositif de découplage capacitif comporte au moins une ligne micro ruban (37) présentant une découpe transversale (38), ladite découpe transversale (38) séparant ladite ligne micro ruban (37) en deux parties (39, 40) reliées entre elles par des condensateurs (41) de découplage.

13. Système selon la revendication 5, **caractérisé en ce que** ladite électrode émettrice (42) comporte une ligne micro ruban (42) présentant à chacune de ses extrémités une découpe traversante (43, 44), séparant ladite ligne micro ruban (42) en deux partie latérales (45, 46) et une partie centrale (47), ladite partie centrale (47) étant reliée à chacune des parties latérales (45, 46) par des condensateurs (48), chaque ensemble découpe traversante (43, 44)/condensateurs (48)/partie latérale (45, 46) qui est situé à chaque extrémité de ladite ligne micro ruban (42) constituant un dispositif de découplage capacitif.

14. Système selon la revendication 5, **caractérisé en ce que** le dispositif de découplage comporte au moins un condensateur (21) compatible avec la tension électrique, et des éléments d'adaptation (25, 31, 33a et 33b) de l'impédance dudit condensateur.

15. Système selon la revendication 14, **caractérisé en ce que** ledit condensateur a une forme allongée et lesdits éléments d'adaptation (25, 31, 33a, 33b) comportent au moins une armature métallique (25, 31, 33a, 33b) disposée au voisinage d'une extrémité de connexion dudit condensateur (21), ladite armature venant entourer ledit condensateur (21) sensiblement sur toute sa longueur.

16. Système selon la revendication 14 ou 15, **caractérisé en ce que** le dispositif de découplage comporte au moins deux armatures métalliques (25, 31, 33a, 33b), chacune des armatures (25, 31, 33a, 33b) étant disposée au voisinage d'une extrémité de connexion dudit condensateur (21), les deux armatures (25, 31, 33a, 33b) étant séparées par un élément isolant appartenant au groupe comprenant l'air, le vide et un matériau diélectrique.

17. Système selon la revendication 15 ou 16, **caractérisé en ce que** une armature (25, 31, 33a, 33b) présente une forme de coupelle.

18. Système selon la revendication la revendication 16 ou 17, **caractérisé en ce que** lesdites armatures (25, 31, 33a, 33b) sont disposées tête-bêche.

19. Système selon la revendication 18, **caractérisé en ce que** les bords libres des armatures (25, 31, 33a, 33b) se chevauchent autour dudit condensateur (21).

20. Système selon l'une quelconque des revendications 14 à 19, **caractérisé en ce que** le dispositif de découplage comporte un boîtier (22) comprenant ledit condensateur (21) et lesdits éléments d'adaptation (25, 31, 33a, 33b), ledit boîtier (22) comprenant au moins deux connecteurs (23, 24).

21. Système selon la revendication 14, **caractérisé en ce que** le dispositif de découplage comporte au moins une ligne micro ruban (37) présentant une découpe transversale (38), ladite découpe transversale (38) séparant ladite ligne micro ruban (37) en deux parties (39, 40) reliées entre elles par des condensateurs (41) de découplage.

22. Système selon la revendication 5, **caractérisé en ce que** l'électrode émettrice comporte une ligne micro ruban (42) présentant à chacune de ses extrémités une découpe traversante (43, 44), séparant ladite ligne micro ruban (42) en deux partie latérales (45, 46) et une partie centrale (47), ladite partie centrale (47) étant reliée à chacune des parties latérales (45, 46) par des condensateurs (48), chaque ensemble découpe traversante (43, 44)/condensateurs (48)/partie latérale (45, 46) qui est situé à chaque extrémité de ladite ligne micro ruban (42) constituant un dispositif de découplage capacitif.

**Patentansprüche**

1. System zum Emittieren mindestens eines elektrischen Impulses für eine Vorrichtung zum Ermitteln einer Verteilung von Ladungen, die in der Dicke eines Elements (2) aus dielektrischem Material enthalten sind, wobei das System zum Emittieren eine Elektrode (1, 42) zum Emittieren mindestens eines Impulses und einen Generator (3) des Impulses aufweist,

**dadurch gekennzeichnet, dass** die Elektrode durch eine Übertragungsleitung (1) gebildet ist, die hinsichtlich des zu analysierenden Elements (2) im Wesentlichen eben ist, und die Mittel für eine Impedanzanpassung aufweist, um die Impedanz entlang der Übertragungsleitung in dem Passband des Impulses im Wesentlichen konstant zu halten,
und dass die Mittel für eine Impedanzanpassung (12, 13, 14, 18, 19, 20) Mittel aufweisen zum elektrischen Verbinden (18, 19) einerseits zwischen dem Impulsgenerator (3) und einem Ende der Emitterelektrode (1, 42) und andererseits zwischen einem zweiten Ende der Emitterelektrode und einer Ladung (20), deren Impedanz gleich der für die Elektrode charakteristischen Impedanz ist.

2. System gemäß Anspruch 1, **dadurch gekennzeichnet, dass** die Verbindungsmittel (18, 19) Koaxialkabel sind.

**3.** System gemäß Anspruch 1 oder 2, **dadurch gekennzeichnet, dass** die Impedanz im Wesentlichen 50 Ohm beträgt.

**4.** System gemäß irgendeinem der Ansprüche 1 bis 3, **dadurch gekennzeichnet, dass** die Ladung durch einen Schaltkreis zum Absorbieren (12, 13, 14) des Signals gebildet ist, der der Elektrode (1, 42) nachgeschaltet ist.

**5.** System gemäß irgendeinem der vorhergehenden Ansprüche, **dadurch gekennzeichnet, dass** es ferner aufweist Mittel (16, 17) zum Anlegen einer elektrischen Polarisierungsspannung an die Elektrode (1, 42) und mindestens eine kapazitive Entkopplungsvorrichtung (15, 29, 32, 36) der Elektrode (1, 42), die an einem Ende der Elektrode angeordnet ist.

**6.** System gemäß Anspruch 5, **dadurch gekennzeichnet, dass** die Entkopplungsvorrichtung (15, 29, 32, 36) aufweist mindestens einen Kondensator (21), der mit der elektrischen Spannung kompatibel ist, und Mittel zum Anpassen (25, 31, 33a und 33b) der Impedanz des Kondensators.

**7.** System gemäß Anspruch 6, **dadurch gekennzeichnet, dass** der Kondensator eine langgestreckte Form hat und die Elemente zum Anpassen (25, 31, 33a, 33b) mindestens eine Metallarmierung (25, 31, 33a, 33b) aufweisen, die benachbart zu einem Anschlussende des Kondensators (21) angeordnet ist, wobei die Armierung den Kondensator (21) im Wesentlichen auf seiner gesamten Länge umgibt.

**8.** System gemäß Anspruch 6 oder 7, **dadurch gekennzeichnet, dass** es mindestens zwei Metallarmierungen (25, 31, 33a, 33b) aufweist, wobei jede der Armierungen (25, 31, 33a, 33b) benachbart zu einem Anschlussende des Kondensators (21) angeordnet ist, wobei die beiden Armierungen (25, 31, 33a, 33b) durch ein isolierendes Element getrennt sind, das zu der Gruppe gehört, die Luft, Vakuum und ein dielektrisches Material aufweist.

**9.** System gemäß Anspruch 8, **dadurch gekennzeichnet, dass** die Armierungen (25, 31, 33a, 33b) entgegengesetzt angeordnet sind.

**10.** System gemäß Anspruch 9, **dadurch gekennzeichnet, dass** sich die freien Ränder der Armierungen (25, 31, 33a, 33b) um den Kondensator (21) herum überlappen.

**11.** System gemäß irgendeinem der Ansprüche 6 bis 10, **dadurch gekennzeichnet, dass** die Vorrichtung zum Entkoppeln (15, 29, 32) ein Gehäuse (22) aufweist, welches den Kondensator (21) und die Elemente zum Anpassen (25, 31, 33a, 33b) aufweist, wobei das Gehäuse (22) mindestens zwei Verbinder (23, 24) aufweist und mit einer Masseplatte verbunden ist.

**12.** System gemäß Anspruch 5, **dadurch gekennzeichnet, dass** die kapazitive Entkopplungsvorrichtung mindestens eine Mikrobandleitung (37) aufweist, die einen transversalen Ausschnitt (38) aufweist, wobei der transversale Ausschnitt (38) die Mikrobandleitung (37) in zwei Teile (39, 40) teilt, die durch Entkopplungskondensatoren (41) miteinander verbunden sind.

**13.** System gemäß Anspruch 5, **dadurch gekennzeichnet, dass** die Emitterelektrode (42) eine Mikrobandleitung (42) aufweist, die an jedem ihrer Enden einen durchgehenden Ausschnitt (43, 44) aufweist, der die Mikrobandleitung (42) in zwei seitliche Teile (45, 46) und einen zentralen Teil (47) teilt, wobei der zentrale Teil (47) mit jedem der seitlichen Teile (45, 46) durch Kondensatoren (48) verbunden ist, wobei jeder Satz von durchgehendem Ausschnitt (43, 44) / Kondensatoren (48) / seitlichem Teil (45, 46), der sich an jedem Ende der Mikrobandleitung (42) befindet, eine kapazitive Entkopplungsvorrichtung ausbildet.

**14.** System gemäß Anspruch 5, **dadurch gekennzeichnet, dass** die Entkopplungsvorrichtung mindestens einen Kondensator (21), der mit der elektrischen Spannung kompatibel ist, und Elemente zum Anpassen (25, 31, 33a und 33b) der Impedanz des Kondensators aufweist.

**15.** System gemäß Anspruch 14, **dadurch gekennzeichnet, dass** der Kondensator eine langgestreckte Form hat und die Elemente zum Anpassen (25, 31, 33a, 33b) mindestens eine Metallarmierung (25, 31, 33a, 33b) aufweisen, die benachbart zu einem Anschlussende des Kondensators (21) angeordnet ist, wobei die Armierung den Kondensator (21) im Wesentlichen auf seiner gesamten Länge umgibt.

**16.** System gemäß Anspruch 14 oder 15, **dadurch gekennzeichnet, dass** die Entkopplungsvorrichtung mindestens zwei Metallarmierungen (25, 31, 33a, 33b) aufweist, wobei jede der Armierungen (25, 31, 33a, 33b) benachbart zu einem Anschlussende des Kondensators (21) angeordnet ist, wobei die beiden Armierungen (25, 31, 33a, 33b) durch ein isolierendes Element getrennt sind, das zu der Gruppe gehört, die Luft, Vakuum und ein dielektrisches Material aufweist.

17. System gemäß Anspruch 15 oder 16, **dadurch gekennzeichnet, dass** eine Armierung (25, 31, 33a, 33b) eine Manschettenform aufweist.

18. System gemäß Anspruch 16 oder 17, **dadurch gekennzeichnet, dass** die Armierungen (25, 31, 33a, 33b) entgegengesetzt angeordnet sind.

19. System gemäß Anspruch 18, **dadurch gekennzeichnet, dass** sich die freien Ränder der Armierungen (25, 31, 33a, 33b) um den Kondensator (21) herum überlappen.

20. System gemäß irgendeinem der Ansprüche 14 bis 19, **dadurch gekennzeichnet, dass** die Entkopplungsvorrichtung ein Gehäuse (22) aufweist, das den Kondensator (21) und die Elemente zum Anpassen (25, 31, 33a, 33b) aufweist, wobei das Gehäuse (22) mindestens zwei Verbinder (23, 24) aufweist.

21. System gemäß Anspruch 14, **dadurch gekennzeichnet, dass** die Entkopplungsvorrichtung mindestens eine Mikrobandleitung (37) aufweist, die einen transversalen Ausschnitt (38) aufweist, wobei der transversale Ausschnitt (38) die Mikrobandleitung (37) in zwei Teile (39, 40) teilt, die durch Entkopplungskondensatoren (41) miteinander verbunden sind.

22. System gemäß Anspruch 5, **dadurch gekennzeichnet, dass** die Emitterelektrode eine Mikrobandleitung (42) aufweist, die an jedem ihrer Enden einen durchgehenden Ausschnitt (43, 44) aufweist, der die Mikrobandleitung (42) in zwei seitliche Teile (45, 46) und einen zentralen Teil (47) teilt, wobei der zentrale Teil (47) mit jedem der seitlichen Teile (45, 46) durch Kondensatoren (48) verbunden ist, wobei jeder Satz durchgehender Ausschnitt (43, 44) / Kondensatoren (48) / seitlicher Teil (45, 46), der sich an jedem Ende der Mikrobandleitung (42) befindet, eine kapazitive Entkopplungsvorrichtung ausbildet.

## Claims

1. A system for transmitting at least one electric pulse for an apparatus for determining a distribution of charges contained in the thickness of an item (2) made of dielectric material, said transmission system including a transmitter electrode (1, 42) for transmitting at least one pulse and a generator (3) of said pulse,
**characterized in that** said electrode is formed by a transmission line (1) which is substantially level in relation to the item (2) to be analyzed and which includes impedance matching means to keep said impedance substantially constant along said transmission line in the passband of said pulse;
and **in that** said impedance matching means (12, 13, 14, 18, 19, 20) include electric link means (18, 19) between, on the one hand, the pulse generator (3) and one end of the transmitter electrode (1, 42), and, on the other hand, between a second end of the transmitter electrode and a load (20), the impedance of which is equal to the characteristic impedance of the electrode.

2. A system according to Claim 1, **characterized in that** said link means (18, 19) are coaxial cables.

3. A system according to Claim 1 or Claim 2, **characterized in that** said impedance is substantially 50 ohms.

4. A system according to any one of the preceding claims, **characterized in that** said load is formed by a circuit (12; 13, 14) for absorbing the signal, located downstream of said electrode (1, 42).

5. A system according to any one of the preceding claims, **characterized in that** it additionally includes means (16, 17) for applying a polarizing electric voltage to said electrode (1, 42) and at least one capacitive decoupling device (15, 29, 32, 36) for said electrode (1, 42) arranged at one end of said electrode.

6. A system according to Claim 5, **characterized in that** said decoupling device (15, 29, 32, 36) includes at least one capacitor (21) which is compatible with the electric voltage, and components (25, 31, 33a and 33b) for matching the impedance of said capacitor.

7. A system according to Claim 6, **characterized in that** said capacitor has an elongated shape and said matching components (25, 31, 33a, 33b) include at least one metal structure (25, 31, 33a, 33b) arranged in proximity to one connection end of said capacitor (21), said structure surrounding said capacitor (21) substantially over its entire length.

8. A system according to Claim 6 or Claim 7, **characterized in that** it includes at least two metal structures (25, 31, 33a, 33b), each of the structures (25, 31, 33a, 33b) being arranged in proximity to one connection end of said capacitor (21), the two structures (25, 31, 33a, 33b) being separated by an insulating item belonging to the group comprising air, vacuum and a dielectric material.

9. A system according to Claim 8, **characterized in that** said structures (25, 31, 33a, 33b) are arranged tete-beche.

10. A system according to Claim 9, **characterized in that** the free edges of the structures (25, 31, 33a, 33b) overlap around said capacitor (21).

11. A system according to any one of Claims 6 to 10, **characterized in that** said decoupling device (15, 29, 32) includes a casing (22) comprising said capacitor (21) and said matching components (25, 31, 33a, 33b), said casing (22) comprising at least two connectors (23, 24) and being connected to a ground plane.

12. A system according to Claim 5, **characterized in that** said capacitive decoupling device includes at least one microstrip line (37) having a transversal cut (38), said transversal cut (38) dividing said microstrip line (37) into two parts (39, 40) which are interconnected by decoupling capacitors (41).

13. A system according to Claim 5, **characterized in that** said transmitter electrode (42) includes a microstrip line (42) having at each of its ends a traversing cut (43, 44), dividing said microstrip line (42) into two side parts (45, 46) and one central part (47), said central part (47) being connected to each of the side parts (45, 46) by capacitors (48), each traversing-cut (43, 44)/capacitors (48)/side-part (45, 46) assembly which is located at each end of said microstrip line (42) forming a capacitive decoupling device.

14. A system according to Claim 5, <u>**characterized in that** the decoupling device</u> includes at least one capacitor (21) which is compatible with the electric voltage, and components (25, 31, 33a and 33b) for matching the impedance of said capacitor.

15. A system according to Claim 14, **characterized in that** said capacitor has an elongated shape and said matching components (25, 31, 33a, 33b) include at least one metal structure (25, 31, 33a, 33b) arranged in proximity to one connection end of said capacitor (21), said structure surrounding said capacitor (21) substantially over its entire length.

16. A system according to Claim 14 or Claim 15, **characterized in that** the decoupling device includes at least two metal structures (25, 31, 33a, 33b), each of the structures (25, 31, 33a, 33b) being arranged in proximity to one connection end of said capacitor (21), the two structures (25, 31, 33a, 33b) being separated by an insulating item belonging to the group comprising air, vacuum and a dielectric material.

17. A system according to Claim 15 or Claim 16, **characterized in that** a structure (25, 31, 33a, 33b) exhibits a cup shape.

18. A system according to Claim 16 or Claim 17, **characterized in that** said structures (25, 31, 33a, 33b) are arranged tete-beche.

19. A system according to Claim 18, **characterized in that** the free edges of the structures (25, 31, 33a, 33b) overlap around said capacitor (21).

20. A system according to any one of Claims 14 to 19, **characterized in that** the decoupling device includes a casing (22) comprising said capacitor (21) and said matching components (25, 31, 33a, 33b), said casing (22) comprising at least two connectors (23, 24).

21. A system according to Claim 14, **characterized in that** the decoupling device includes at least one microstrip line (37) having a transversal cut (38), said transversal cut (38) dividing said microstrip line (37) into two parts (39, 40) which are interconnected by decoupling capacitors (41).

22. A system according to Claim 5, **characterized in that** the transmitter electrode includes a microstrip line (42) having

at each of its ends a traversing cut (43, 44), dividing said microstrip line (42) into two side parts (45, 46) and one central part (47), said central part (47) being connected to each of the side parts (45, 46) by capacitors (48), each traversing-cut (43, 44)/capacitors (48)/side-part (45, 46) assembly which is located at each end of said microstrip line (42) forming a capacitive decoupling device.

Art Antérieur          FIG.1

FIG.2

FIG.3

FIG.4

FIG.5

FIG.7

FIG.6

FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **FUKUNAGA et al.** Internai space charge measurement for space environment monitoring. *Proceedings of the 7th International Conference on Properties and Applications of Dielectric Materials,* 01 Juin 2003, vol. 2, 662-664

- **TATSUO TAKADA.** Acoustic and Optical Methods for Measuring Electric Charge Distributions in Dielectrics. *IEEE Transactions on Dielectrics and Electrical Insulation,* 01 Octobre 1999, vol. 6, 519-547
- INNOVATIVE PEA SPACE CHARGE MEASUREMENT SYSTEMS FOR INDUSTRIAL APPLICATIONS. *IEEE Electrical Insulation Magazine,* Mars 2004, vol. 20 (2